**Europäisches Patentamt**

**European Patent Office**

**Office européen des brevets**

(19)

(11) Veröffentlichungsnummer: **0 104 615**
**A2**

# (12) EUROPÄISCHE PATENTANMELDUNG

(21) Anmeldenummer: **83109452.9**

(22) Anmeldetag: **22.09.83**

(51) Int. Cl.³: **H 01 L 27/10**
**G 11 C 11/34**

(30) Priorität: **28.09.82 DE 3235835**

(43) Veröffentlichungstag der Anmeldung:
**04.04.84 Patentblatt 84/14**

(84) Benannte Vertragsstaaten:
**AT DE FR GB IT**

(71) Anmelder: **SIEMENS AKTIENGESELLSCHAFT**
**Berlin und München Wittelsbacherplatz 2**
**D-8000 München 2(DE)**

(72) Erfinder: **Wieder, Armin, Dr.-Ing.**
**Zentnerstrasse 20**
**D-8000 München 40(DE)**

(54) **Halbleiter-Speicherzelle.**

(57) Halbleiterspeicherzelle mit einer einen Speicherbereich (SP) definierenden Speicherelektrode (5), die auf der Grenzfläche eines Halbleiterkörpers isoliert angeordnet ist, und mit einem Auswahltransistor, der ein mit einer Bitleitung verbundenes, zum Halbleiterkörper entgegengesetzt dotiertes Anschlußgebiet (8) aufweist. Angestrebt wird, beide logischen Zustände der Zelle ohne äußere Regeneriermaßnahmen beliebig lange zu speichern. Das wird durch einen Absaugtransistor erreicht, dessen Gate (9) einen neben dem Speicherbereich (SP) liegenden Halbleiterbereich (AS) überdeckt und mit der Grenzfläche im Speicherbereich leitend verbunden ist, wobei der Absaugtransistor ein Absauggebiet (10) aufweist, das kapazitiv mit dem Gate (9) des Absaugtransistors verbunden und mit einer Absangtaktspannung ($V_P$) beschaltet ist. Der Anwendungsbereich umfaßt VLSI-Speicherapplikationen.

FIG 1

EP 0 104 615 A2

SIEMENS AKTIENGESELLSCHAFT
Berlin und München

Unser Zeichen
VPA 82 P 1896 E

Halbleiter-Speicherzelle

Die Erfindung bezieht sich auf eine Halbleiter-Speicherzelle nach dem Oberbegriff des Patentanspruchs 1.

Bei Speicherzellen dieser Art wird in Abhängigkeit von dem jeweils gespeicherten Signal zwischen zwei logischen Zuständen unterschieden. Der eine ("0"-Zustand) ist durch das Vorhandensein einer Inversionsschicht an der Grenzfläche des Halbleiterkörpers unterhalb der Speicherelektrode gekennzeichnet, der andere ("1"-Zustand) durch das Fehlen derselben. Nachteilig ist jedoch, daß nur der "0"-Zustand stabil ist. Der "1"-Zustand strebt wegen der thermischen Ladungsträgergeneration in der Raumladungszone unterhalb der Speicherelektrode dem "0"-Zustand zu und bedarf daher einer periodischen Regenerierung.

Der Erfindung liegt die Aufgabe zugrunde, eine Halbleiter-Speicherzelle der eingangs genannten Art anzugeben, in der beide logischen Zustände beliebig lange gespeichert werden können, ohne regeneriert werden zu müssen, so daß die Funktion einer statischen Speicherzelle erreicht wird. Diese Aufgabe wird erfindungsgemäß durch eine Ausbildung der Speicherzelle nach dem kennzeichnenden Teil des Patentanspruchs 1 gelöst.

Der mit der Erfindung erzielbare Vorteil liegt insbesondere darin, daß die Funktion einer statischen Speicherzelle über ein zustandsabhängig gesteuertes Absaugen des Generationstromes erreicht wird, was lediglich einen Mehraufwand von einem Transistor pro Speicherzelle erfordert. Damit ist die Speicherzelle nach der Erfindung wesentlich flächensparender aufgebaut als eine statische Speicherzelle herkömmlicher Art, die im allgemeinen aus sechs Transistoren besteht. Weiterhin ergibt sich ein äußerst geringer Leistungsbedarf, da ähnlich wie bei CMOS-Speicherzellen praktisch kein Strom zur Aufrechterhaltung des gespeicherten Zustands verbraucht wird. Die vorstehend angeführten Eigenschaften lassen VLSI-Applikationen der Speicherzelle zu. Hierzu trägt auch die geringe, einstellbare $\alpha$-Teilchen-Empfindlichkeit bei.

Die Erfindung wird nachfolgend anhand eines in der Zeichnung dargestellten, bevorzugten Ausführungsbeispiels näher erläutert. Dabei wird von einer Speicherzelle ausgegangen, die in einer Zwei-Lagen-Technologie realisiert ist, d. h. mit zwei übereinander liegenden Schichten aus polykristallinem Silizium versehen ist.

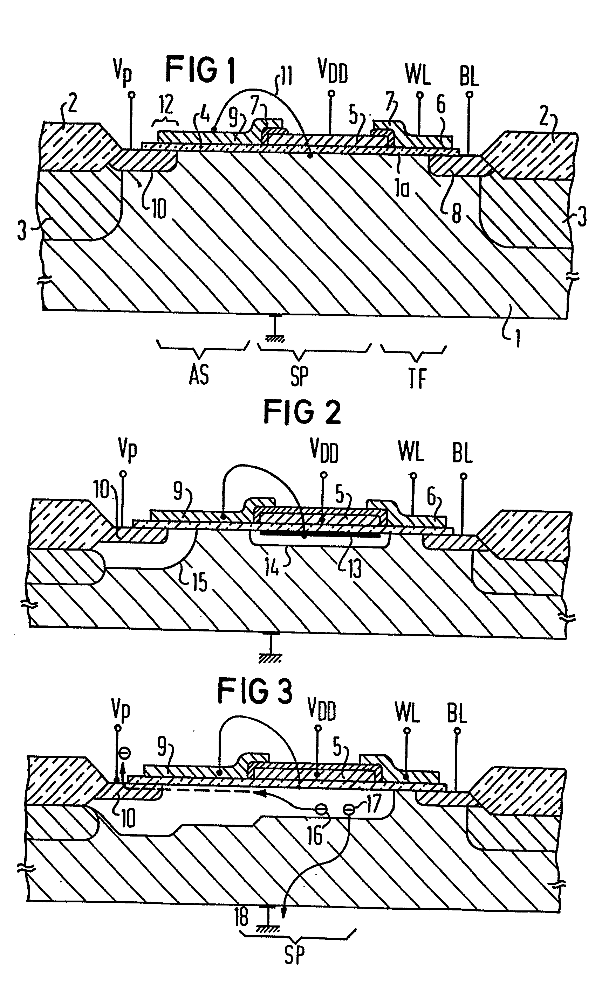

Ein Halbleiterkörper 1 aus z. B. p-dotiertem Silizium ist mit einer Feldoxidschicht 2 versehen, unter der sich eine Feldimplantation 3 befindet, die die Grunddotierung von 1 verstärkt. Auf einer Gateoxidschicht 4 ist eine Speicherelektrode 5 aus polykristallinem Silizium aufgebracht, die über einen Anschluß mit der Versorgungsspannung $V_{DD}$ beschaltet ist. Der Bereich des Halbleiterkörpers, der sich unterhalb von 5 und nahe der Grenzfläche 1a befindet, wird auch als Speicherbereich SP bezeichnet. An diesen schließt sich nach rechts ein Transferbereich TF des Halbleiterkörpers an, der durch ein auf der Schicht 4 angeordnetes Gate 6 überdeckt wird. Das Gate 6 ist dabei mit einer Wortleitung WL verbunden, wie in Fig. 1 angedeutet ist. Es besteht aus einer zweiten Schicht aus polykristallinem Silizium, die über der ersten angebracht ist und durch eine isolierende Zwischenschicht 7 von dieser getrennt ist. Ein $n^+$-dotiertes Halbleitergebiet 8 ist in den Halbleiterkörper 1 so eingefügt, daß es sich bis zur Grenzfläche 1a erstreckt. Es ist mit einer Bitleitung BL verbunden, wie in Fig. 1 angedeutet ist. Die Teile 6 und 8 bilden einen Auswahltransistor, über den der Speicherbereich SP mit der Bitleitung BL verbunden ist.

Nach links schließt sich an den Speicherbereich SP ein Absaugbereich AS an, der von einem Gate 9 überdeckt wird. Dieses Gate ist ebenso wie 6 aus der zweiten Schicht aus polykristallinem Silizium gebildet und durch die Zwischenschicht 7 von der Speicherelektrode 5 getrennt. Schließlich ist links von AS ein $n^+$-dotiertes Halbleitergebiet 10 so in 1 eingefügt, daß es sich bis zur Grenzfläche 1a erstreckt. Es ist mit einer Absaugtaktspannung $V_P$ beschaltet, wie Fig. 1 erkennen läßt. Das Gebiet 10 bildet mit dem Gate 9 einen Absaugtransistor.

Zwischen der Grenzfläche 1a im Speicherbereich SP und dem Gate 9 des Absaugtransistors besteht eine leitende Verbindung, was in Fig. 1 durch einen Bügel 11 dargestellt wird. Weiterhin können die im Querschnitt dargestellten Halbleitergebiete 8 und 10 auch aus Abschnitten von durchlaufenden, in den Halbleiterkörper 1 eindiffundierten Leitungen bestehen, die jeweils an ihren Enden mit den in Fig. 1 angedeuteten Anschlüssen versehen sind. Das Gate 9 ist so auf der Gateoxidschicht 4 angeordnet, daß es den Bereich 10 etwas überdeckt, wie bei 12 angedeutet ist. Dadurch entsteht eine kapazitive Kopplung zwischen diesen Teilen.

Fig. 2 zeigt den "0"-Zustand der Speicherzelle. Wegen der vorhandenen Inversionsschicht 13 unterhalb von 5 ist das Oberflächenpotential im Bereich SP relativ niedrig, so daß auch das Gate 9 auf diesem relativ niedrigen Potential liegt. Damit wird aber die Einsatzspannung des Absaugtransistors 9,10 unterschritten, so daß dieser nicht leitet. Das hat zur Folge, daß die Inversionsschicht 13 bestehen bleibt und der "0"-Zustand stabil ist. Mit 14 und 15 sind die Grenzen der Raumladungszonen unterhalb von 5 und 10 bezeichnet.

Fig. 3 zeigt den "1"-Zustand. Hierbei wird das relativ hohe Oberflächenpotential des Speicherbereiches SP auf das Gate 9 des Absaugtransistors geschaltet, so daß dieser leitet. Das Gate 9 liegt etwa auf dem um den Wert der Einsatzspannung reduzierten Potential der Speicherelektrode 5 und wird hiervon ausgehend bei Zuführung der Absaugtaktspannung $V_p$ an 10 wegen der kapazitiven Kopplung abwechselnd auf ein höheres und ein tieferes Potential geschaltet. Das führt zu einem periodischen Absaugen der Elektronen 16, die sich durch Generation im Speicherbereich SP angesammelt haben, so daß auch dieser Zustand stabil ist. Die Löcher 17 werden zur Elektrode 18 transportiert, die auf Bezugspotential liegt. Ist das Potential des Gebietes 10 stets höher als das Potential von 5, reduziert um den doppelten Wert der Einsatzspannung, so findet keine Rückinjektion von Elektronen aus dem Gebiet 10 statt.

Der "0"-Zustand bleibt auch bei einem $\alpha$-Teilchen-Treffer erhalten. Im "1"-Zustand können durch $\alpha$-Teilchen generierte Elektronen über den Absaugtransistor 9,10 entsprechend der verwendeten Taktfrequenz von $V_p$ abgesaugt werden, so daß dieser Zustand eine erheblich reduzierte $\alpha$-Teilchen-Empfindlichkeit besitzt.

Die Ansteuerung der Speicherzelle nach der Erfindung entspricht der bei dynamischen Ein-Transistor-Speicherzellen. Hierzu sei auf das Buch von Luecke, Mize und Carr "Semiconductor Memory Design and Application", Verlag McGraw-Hill Kogakusha, Ltd., Tokyo 1973, Seiten 123 und 124, hingewiesen.

2 Patentansprüche

3 Figuren

Patentansprüche

1. Halbleiter-Speicherzelle mit einer einen Speicherbereich definierenden, mit einer konstanten Spannung beschalteten Speicherelektrode, die auf der Grenzfläche eines dotierten Halbleiterkörpers isoliert angeordnet ist, und mit einem Auswahltransistor, dessen Gate einen ersten neben dem Speicherbereich liegenden Halbleiterbereich überdeckt, wobei der Auswahltransistor ferner ein mit einer Bitleitung verbundenes, zu dem Halbleiterkörper entgegengesetzt dotiertes Anschlußgebiet aufweist, g e k e n n z e i c h n e t   d u r c h   einen Absaugtransistor mit einem Gate (9), das einen zweiten neben dem Speicherbereich (SP) liegenden Halbleiterbereich (AS) überdeckt und mit der Grenzfläche (1a) im Speicherbereich (SP) leitend verbunden ist (11), und mit einem in den Halbleiterkörper (1) eingefügten, zu diesem entgegengesetzt dotierten Absauggebiet (10), das kapazitiv mit dem Gate (9) des Absaugtransistors verbunden und mit einer Absaugtaktspannung ($V_P$) beaufschlagt ist.

2. Halbleiter-Speicherzellen nach Anspruch 1,   d a - d u r c h   g e k e n n z e i c h n e t ,   daß das Absauggebiet (10) mit einer Absaugleitung verbunden ist, die in den Halbleiterkörper (1) eingefügt, zu diesem entgegengesetzt dotiert und mit der Absaugtaktspannung ($V_P$) beschaltet ist.

**FIG 1**

**FIG 2**

**FIG 3**